(19) Europäisches Patentamt

European Patent Office

Office européen des brevets

(11) **EP 1 117 178 A2**

(12) **EUROPEAN PATENT APPLICATION**

(43) Date of publication:
**18.07.2001 Bulletin 2001/29**

(51) Int Cl.⁷: **H03G 3/30**

(21) Application number: **01100682.2**

(22) Date of filing: **11.01.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **14.01.2000 JP 2000005659**

(71) Applicant: **Pioneer Corporation**
**Meguro-ku, Tokyo (JP)**

(72) Inventor: **Uchiyama, Kazuhiko**
**c/o Pioneer Corp. Kawagoe Works**
**Kawagoe-shi, Saitama (JP)**

(74) Representative: **Manitz, Finsterwald & Partner**
**Postfach 22 16 11**
**80506 München (DE)**

(54) **Receiver for digital broadcasting**

(57)    A receiver for digital broadcasting which receives a digital broadcasting signal of an OFDM system formed of digital data of a frame unit in which a transmitter identification information made of bit groups of a predetermined bit number is included in frame starting information provided at a beginning portions of the frame and indicative of the starting of the frame, corrects a reception signal level of the bit groups to a proper level, and accurately identifies a transmitter from which the receiver is now receiving the digital broadcasting signal transmitted therefrom.

**Description**

BACKGROUND OF THE INVENTION

1. Field of the Invention

The invention relates to a receiver for digital broadcasting, adapted to receive a signal of an OFDM (Orthogonal Frequency Division Multiplexer) system, and more particularly to a receiver for digital broadcasting which is formed so as to accurately correct a reception level of transmitter identification information in a transmission frame even when the transmitter identification information is distorted in a transmission space for a fading phenomenon.

2. Description of the Related Art

It is known that an OFDM is suitable as a modulation system employed in the digital audio broadcasting (which will hereinafter be referred to as DAB). The OFDM system is a multi-carrier modulation system using multiple carriers, which are in orthogonal relation. Therefore, the OFDM system is capable of reducing influence of multi-pass, and has a high frequency utilization efficiency. The OFDM system is formed by broadcasting stations having the same frequency bands in common, and capable of forming a single frequency network (SFN) through which the same program is broadcast at the same time, and expanding a receiving area.

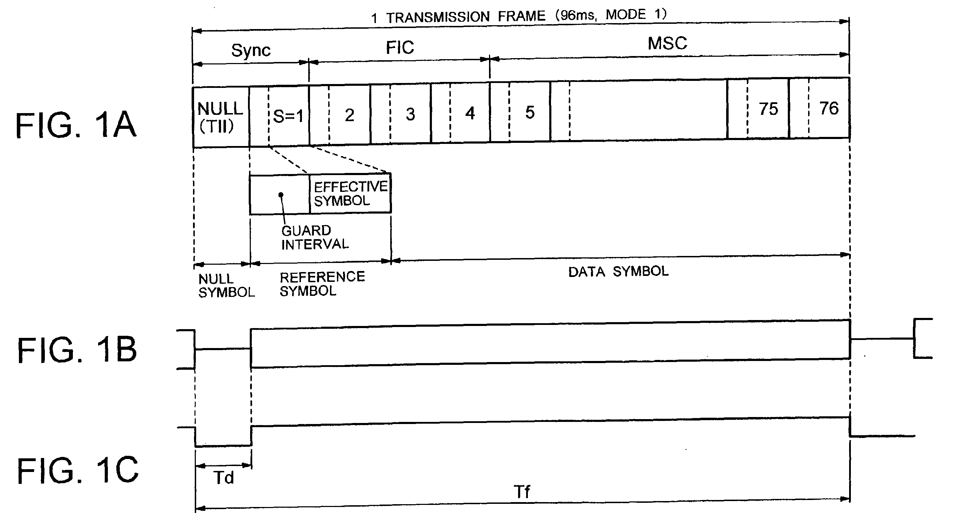

In a DAB system employing an OFDM system, a sending signal is formed by a format shown schematically on a time axis of Fig. 1A. Namely, data are transmitted in blocks of frame, and a NULL section, a reference symbol section and a data section are formed in order in one frame. The NULL section is a period in which a transmission signal does not exist, and a reference symbol bears a reference phase for a differential decoding operation. Main information, such as a sound signal to be primarily transmitted is allotted to the data section. The reference symbol is formed of a front guard interval and a succeeding effective symbol. The data section is a train of symbols provided with guard intervals at the respective front portions. The guard intervals are provided for preventing the influence of inter-symbol interference ascribed to the influence of a multi-pass.

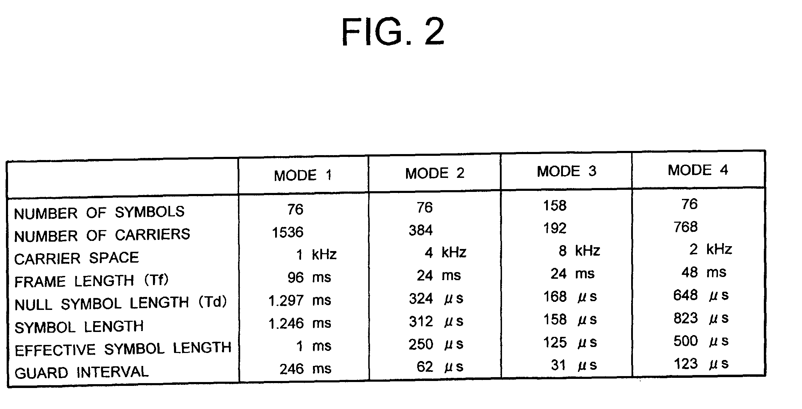

In a DAB system in Europe, three bands, i.e. a band II (87-108 kHz band), a band III (175-250 MHZ band) and an L band (1.452-1.492 GHz band) are used, and four kinds of transmission modes are prescribed as shown in Fig. 2. In the respective transmission modes, the numbers of symbols, effective symbol lengths, the numbers of carriers and so on in one frame are different from each other. In the bands II and III, a transmission mode 1, which is resistant to a multi-pass and suitable for a single-frequency network, having a frame length of 96 ms and a carrier space of 1 kHz is utilized. In the L band, a transmission mode 2, which is resistant to moving, having a frame length of 24 ms and a frequency interval of 4 kHz, a transmission mode 3 (for satellite broadcasting) having a frame length of 24 ms and a frequency interval of 8 kHz, and a transmission mode 4 having a frame length of 48 ms and a frequency interval of 2 kHz are utilized. Accordingly, in a receiver formed so as to be adaptable to a plurality of transmission modes, it is necessary to identify a transmission mode, and carry out demodulation of data and various other kinds of control operations in accordance with the transmission mode.

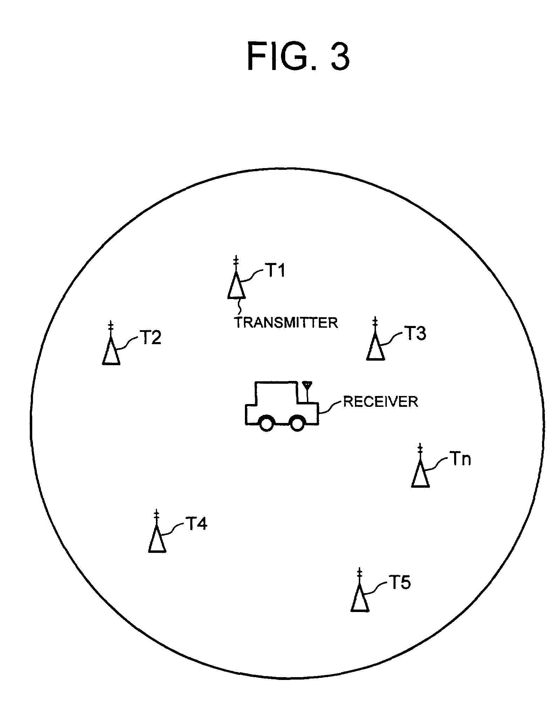

When a DAB system is used, which is resistant to multi-pass trouble, a single-frequency network in which all transmitters T1-Tn transmit signals with the same frequency can be formed as shown in Fig. 3. In the DAB system, transmitter identification information TII peculiar to a transmitter is included in a NULL symbol in every other frame so as to identify a broadcasting area of the DAB system and a transmitter T which is now sending a radio wave of the DAB system received. Therefore, a transmitter T from which a receiver is now receiving a radio wave can be identified by detecting a transmitter identification information TII thereon even when a plurality of transmitters T broadcast the same program at the same time.

A transmitter identification information TII in the transmission mode 1 is expressed by, for example, the following equation (1).

$$Ac,\underset{\sim}{p}(k) = \begin{cases} \sum\limits_{b=0}^{7} \delta\big(k, \quad -768 + 2c + 48b\big) \times ab(\overset{..}{p}), & -768 \leq k < -384 \\ \sum\limits_{b=0}^{7} \delta\big(k, \quad -384 + 2c + 48b\big) \times ab(p), & -384 \leq k < 0 \\ \sum\limits_{b=0}^{7} \delta\big(k, \quad 1 + 2c + 48b\big) \times ab(p), & 0 < k \leq 384 \\ \sum\limits_{b=0}^{7} \delta\big(k, \quad 385 + 2c + 48b\big) \times ab(p), & 384 < k \leq 768 \end{cases} \quad \ldots(1)$$

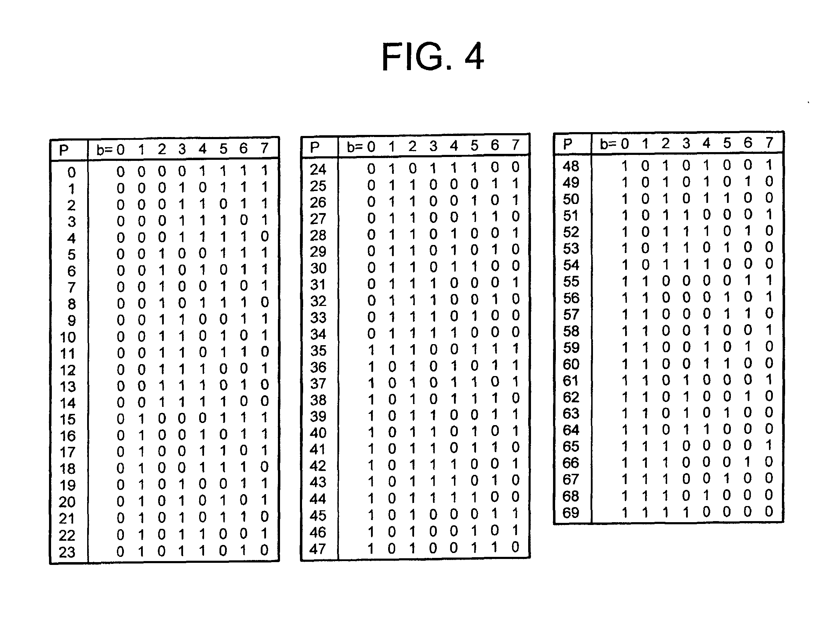

wherein k represents the number of carriers per frame which corresponds to each of the transmission modes; c sub-identification information, a value of 0-23 indicative of an offset of a carrier from a predetermined frequency; p main identification information formed of eight bits and having a bit pattern (a bit pattern of the eight bits will hereinafter be referred to as a bit group) in which four bits of the eight bits necessarily become "1", there being a total of seventy kinds of combinations of bits as shown in Fig. 4; and δ a Kronecker' s symbol.

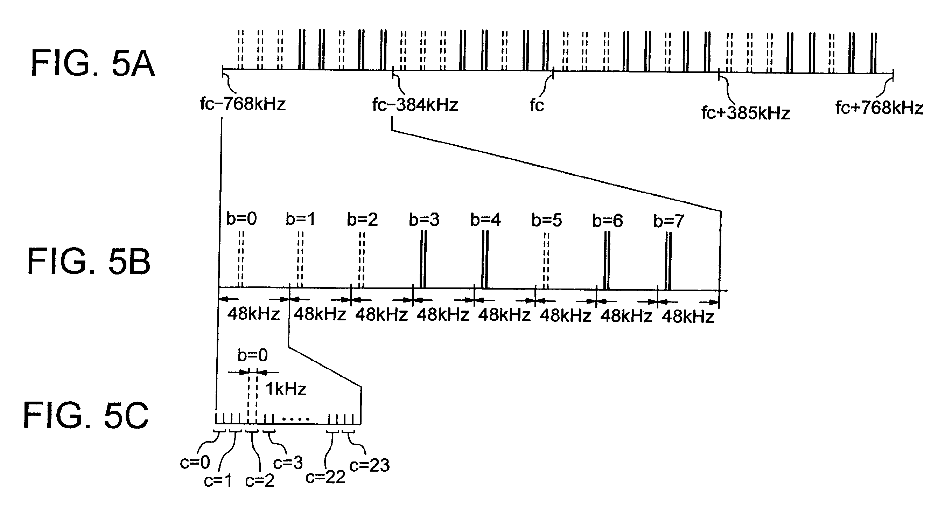

A concrete structure of carriers including main identification information and sub-identification information which constitute transmitter identification information TII will now be described with reference to Figs. 5A to 5C. Fig. 5A shows transmitter identification information TII in the mode 1 by frequency regions.

A transmission signal in the mode 1 has a frequency band of ±768 kHz with respect to a center frequency fc, and is formed of a plurality of carriers existing in the frequency band. The carriers exist at 1 kHz intervals (carrier spaces) with respect to the center frequency fc, and a total number thereof is 1536. Since the transmitter identification information T11 in the mode 1 is a part of the transmission signal in the mode 1, this information has the same frequency band and carrier structure. However, the frequency band of the transmitter identification information TII of the mode 1 is divided into four blocks (fc-768 kHz)-(fc-385 kHz), (fc-384 kHz)-(fc-1 kHz), (fc+1 kHz)-(fc+384 kHz), (fc+385 kHz)-(fc+768 kHz) as shown in Fig. 5A, and each block serves as a bit group mentioned above. Moreover, these blocks have carriers so that the blocks have the same bit pattern. Namely, the transmitter identification information TII in the mode 1 is formed so that it has four bit groups having the same bit pattern in the frequency band.

Since a bit group has a bit pattern in which four bits of eight bits are necessarily "1" as mentioned above, one bit group necessarily has carriers corresponding to four bits. Accordingly, the transmitter identification information TII in the mode 1, which has four bit groups, necessarily has carriers corresponding to sixteen bits in the frequency band. In the transmitter identification information TII of the mode 1, one bit is represented by two carriers (carrier pair) arranged consecutively, so that thirty-two carriers in total, the number of which is two times as large as sixteen bits, exist in the frequency band of the transmitter identification information TII in the mode 1 as shown in Fig 5A.

Namely, the transmitter identification information TII in the mode 1 has four bit groups of the same bit pattern in the frequency band, and each of the bit groups is formed of eight carriers. The carriers constituting these bit groups form main identification information and sub-identification information on the transmitter identification information TII.

How the main (transmitter) identification information and sub-(transmitter) identification information are formed of carriers constituting bit groups will now be described concretely with reference to Figs. 5B and 5C. Fig. 5B shows on an enlarged scale a first bit group forming the frequency band of (fc-768 kHz)-(fc-383 kHz) of the transmitter identification information TII in the mode 1, which represents the case of the bit group ( "00011011" ) for p=2 shown in Fig. 4. In Fig. 5B, "0" is shown by broken lines, and "1" by solid lines. Fig. 5C shows on a further enlarged scale a frequency band corresponding to one bit, which represents carriers with respect to a shifting amount, which will be described later, of c=2.

As shown in Fig. 5B, the bit groups are divided respectively into eight sections of 48 kHz, and one bit is allotted to one section respectively. Namely, each section corresponds to b in Fig. 4, i.e., b=0, b=1, ... , b=7 in the mentioned order from the extreme left section. In short, the main identification information is determined in accordance with a bit pattern formed on the basis of the existence and non-existence of carriers in each section.

The sub-identification information is determined in accordance with a frequency position in which the carriers exist in each section. To be more exact, each section constituting bits has a frequency band for forty-eight carriers, and values of c are determined for every frequency band corresponding to two carriers as shown in Fig 5C. In short, the sub-identification information represents an amount by which the carriers are shifted from a reference frequency in which c=0.

The transmission identification information TII in the mode 4 is expressed by an equation (2), and has two bit groups of the same bit pattern in a frequency band.

$$Ac, p(k) = \begin{cases} \sum_{b=0}^{7} \delta(k, \ -384 + 2c + 48b) \times Xab(p), & -384 \le k < 0 \\ \sum_{b=0}^{7} \delta(k, \ 1 + 2c + 48b) \times ab(p), & 0 < k \le 384 \end{cases} \quad \cdots(2)$$

The transmitter identification information TII in the modes 2 and 3 has only one bit group in the frequency band.

Namely, the transmitter identification information TII represents main identification information and sub-identification information in accordance with a bit pattern of carriers constituting bit groups, and a frequency (shifting amount) at which the carriers exist, though the identification information has a slight structural difference for each transmission mode. Therefore, when the transmitter identification information TII is detected by a receiver to recognize main identification and sub-identification information, it becomes possible to obtain various kinds of information, such as the number of a transmitter T from which a receiver is now receiving a radio wave.

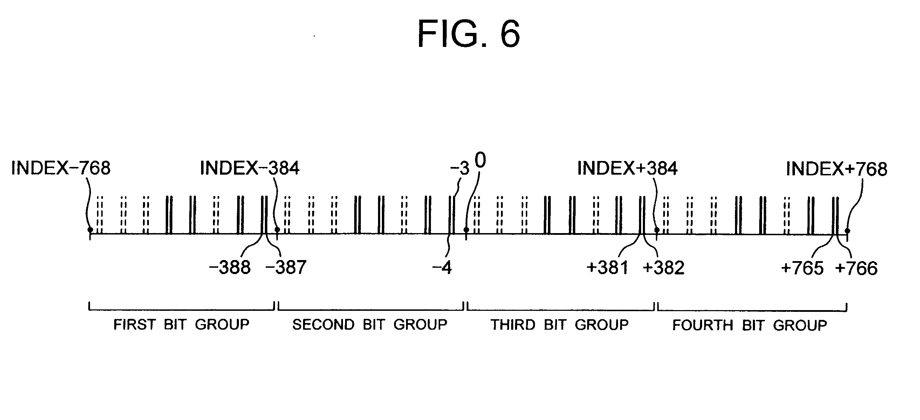

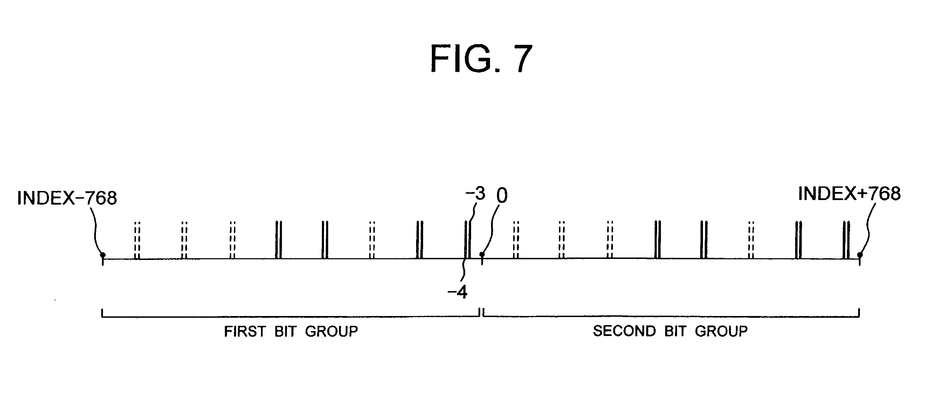

In the description mentioned above, the transmitter identification information TII is described relatively to a frequency region. From the following sentence onward, the transmitter identification information TII will be described by using tentative numbers (index numbers) allotted to carrier frequencies as shown in Figs. 6 and 7. To be more exact, in the case of the mode 1, the carriers in (fc-768 kHz)-(fc-385 kHz) in the frequency region correspond to index numbers of index-768~index-385, the carriers in (fc-384 kHz)-(fc-1 kHz) to index numbers of index-384-index-1, (fc+1)-(fc+384 kHz) in the frequency region to index numbers of index+1~index+384, and the carriers in (fc+385 kHz)-(fc+768 kHz) to index numbers of index+385~index+768 respectively as shown in Fig. 6.

In the mode 4 as well, index numbers are allotted as shown in Fig. 7 in the same corresponding relation as in the mode 1.

In general, a DAB receiver is formed so as to receive at a front end thereof a radio wave from a desired broadcasting station, convert the received radio wave signal into an intermediate frequency (IF) signal, eliminate adjacent radio wave signals by using, for example, a SAW filter as an IF filter, and amplify the resultant intermediate frequency signal by an intermediate frequency amplifier. The structure renders the DAB receiver unable in some cases to detect a proper reception level of a transmitter identification information TII, which has passed through the SAW filter owing to the frequency characteristics thereof, due to the occurrence of distortion of the transmitter identification information TII or the occurrence of a dip of the frequency characteristics of a spatial transmission passage between a transmitter T and a receiver because of radio wave trouble, such as a fading phenomenon. The proper reception level of the transmitter identification information TII referred to above means a reception level of the same information TII attenuated in proportion to a distance between the transmitter and DAB receiver. When the distortion of the transmission identification information TII is large, the DAB receiver cannot recognize the transmitter identification information TII.

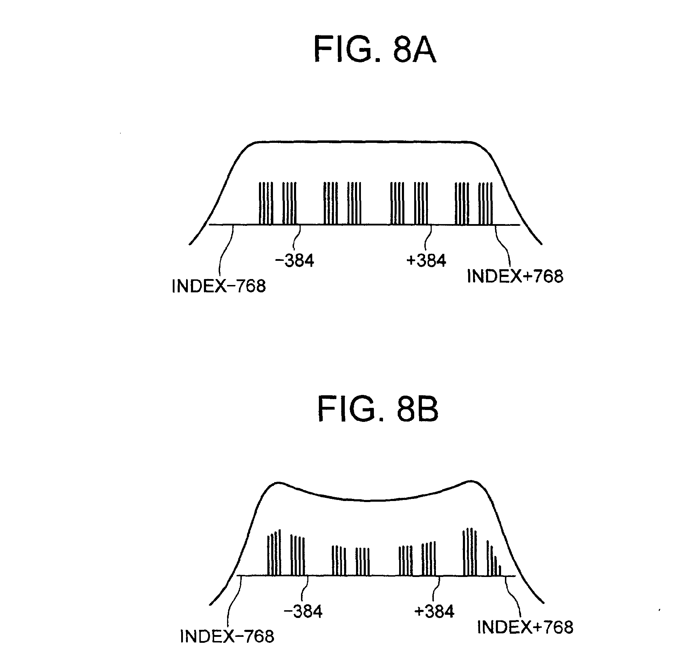

Figs. 8A and 8B schematically show the relations between the frequency characteristics of a SAW filter and the carriers of the transmitter identification information TII in the mode 1, which are replaced with index numbers. As shown in Fig. 8A, when a frequency characteristic line of the SAW filter is flat and wide, all carriers can be received at the same level. However, when a frequency characteristic line of the SAW filter is bent at, for example, an intermediate portion thereof as shown in Fig. 8B, attenuation occurs in some of the carriers. When radio wave trouble, such as a fading phenomenon occurs, a dip occurs in the frequency characteristics of a spatial transmission passage between the transmitter T and receiver, and attenuation occurs in some carriers even when the frequency characteristic line of the SAW filter is flat and wide. Therefore, in the DAB receiver thus formed, a transmitter identification information TII cannot be received at a proper reception level.

SUMMARY OF THE INVENTION

It is therefore an object of the present invention to provide a receiver for digital broadcasting which is capable of correcting a reception level of transmitter identification information TII distorted due to the frequency characteristics of a transmission system or a SAW filter to a proper signal level.

According to the present invention, a receiver for receiving a digital broadcasting signal having a frame structure which is modulated with an OFDM system, the frame including a plurality of symbols each of which includes a plurality of carriers in a predetermined frequency band, the frame further including at a beginning portion thereof frame starting information indicative of the starting of the frame, the frame starting information including a symbol having auxiliary data which is necessary for reception, comprising correction means for correcting a carrier signal level of the symbol having the auxiliary data.

According to the present invention, the receiver further includes storage means for storing an attenuation amount of the carrier signal which is attenuated due to the filtering characteristic of an IF filter, the correction means corrects the carrier signal level on the basis of data of the attenuation amount stored in the storage means.

According to the present invention, the receiver further includes detection means for detecting the carrier signal level of a symbol which is adjacent to a symbol having the auxiliary data with respect to time, the correction means corrects the carrier signal level on the basis of a maximum value of the detected signal level by the detection means and a carrier signal level of the same frequency as a carrier signal to be corrected.

According to the present invention, the symbol having the auxiliary data includes a plurality of bit groups of the same content and the auxiliary data represents a bit group having a plurality of carrier signals, the receiver further includes detection means for detecting a level of each carrier signal constituting the bit group, and arithmetic means for calculating an average of signal levels of the same bits in a plurality of bit groups the basis of the detected results by the detection means, the correction means corrects the carrier signal level on the basis of the results of the arithmetic operation by the arithmetic means.

According to the present invention, the auxiliary data represents a bit group having a plurality of carrier signals, the receiver further includes detection means for detecting a level of each carrier signal constituting the bit group, and arithmetic means for calculating an average of signal levels of the bit group on the basis of the detected results of the detection means, the correction means corrects the carrier signal level on the basis of the results of the arithmetic operation by the arithmetic means.

According to the present invention, the auxiliary data represents a bit group having a plurality of carrier signals, the receiver further includes detection means for detecting a level of each carrier signal constituting the bit group, and arithmetic means for calculating an average of the signal levels of bit groups corresponding to a predetermined period of time on the basis of the detected results of the detection means, the correction means corrects the carrier signal level on the basis of the results of the arithmetic operation by the arithmetic means.

The receiver for digital broadcasting according to the present invention is a receiver capable of receiving a digital broadcasting signal having a frame structure, a beginning portion of the frame including frame starting information (NULL symbols) indicative of the starting of the frame, the frame starting information including auxiliary data (transmitter identification information TII). Since the receiver includes correction means for correcting a carrier signal level of the symbol having the auxiliary data, an accurate reception level of the transmitter identification information TII can be detected.

BRIEF DESCRIPTION OF THE DRAWINGS

Fig. 1A is a diagram showing a frame structure of a transmission signal;
Fig. 1B is a diagram showing the existence and non-existence of a transmission signal;
Fig. 1C is a waveform diagram showing an output signal from a NULL detector;
Fig. 2 is a diagram showing transmission modes of DAB broadcasting;
Fig. 3 is a diagram for describing a single-frequency network;
Fig. 4 is a diagram showing the relation between main identification information and bit patterns of bit groups;
Fig. 5A is a diagram showing carriers in a band of transmitter identification information TII in a transmission mode 1;
Fig. 5B is an enlarged diagram of a first bit group in the band shown in Fig. 5A;
Fig. 5C is an enlarged diagram of one bit of the first bit group shown in Fig. 5B;
Fig. 6 is a diagram showing by index numbers the interior of the band of the transmitter identification information TII in the transmission mode 1;
Fig. 7 is a diagram showing by index numbers the interior of a band of transmitter identification information TII in a transmission mode 4;
Figs. 8A and 8B are diagrams showing the relation between frequency characteristics of a SAW filter and transmitter identification information TII;
Fig. 9 is a block diagram showing an embodiment of the present invention;
Fig. 10A is a diagram showing the frequency characteristic of the SAW filter;
Fig. 10B is a diagram showing correction values for each frequency of the SAW filter;
Fig. 11A is a diagram for describing the case where a distorted reference symbol is received;
Fig. 11B is a diagram showing a distortion amount of the reference symbol;
Figs. 12A-12D are diagrams showing levels of bit groups of the transmitter identification information TII;
Fig. 12E is a diagram showing a level obtained after the transmitter identification information TII is corrected;
Fig. 13 is a diagram for describing the calculation of average levels of bit groups; and
Fig. 14 is a flow chart showing an operation of a system control unit for carrying out a series of correction operations.

DETAILED DESCRIPTION OF THE PREFERRED EMBODIMENT

The construction and operation of a receiver 50 for digital broadcasting according to the present invention will now be described in detail with reference to the drawings.

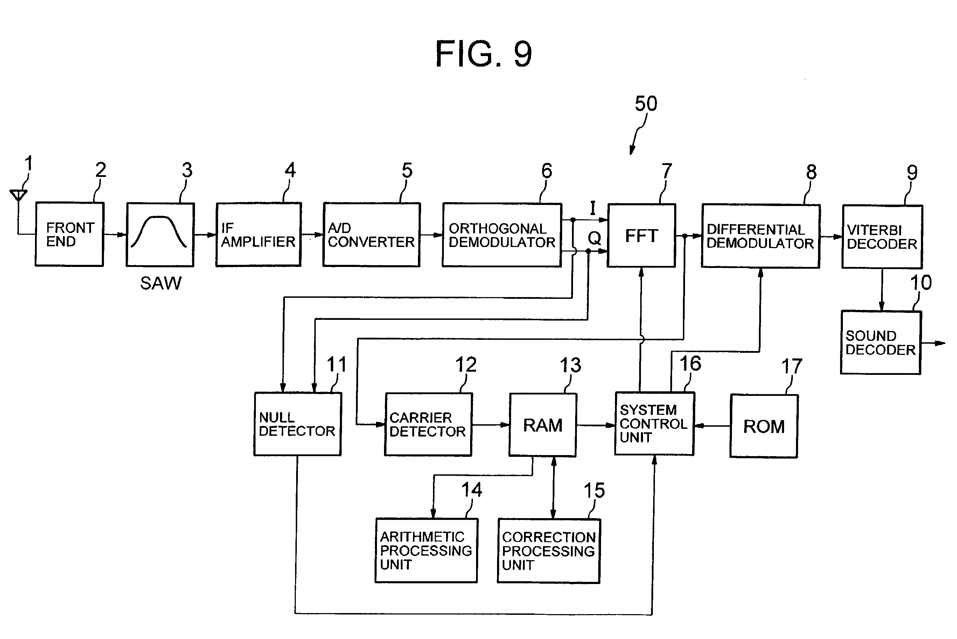

As shown in Fig. 9, in the receiver 50 for digital broadcasting, radio waves received by an antenna 1 are supplied to a front end 2. The front end 2 tunes to a desired frequency to obtain a radio wave of the desired frequency from the radio waves received by the antenna 1, converts the radio wave of the desired frequency into an intermediate frequency signal (IF) by a superheterodyne method, and outputs the resultant signal. The intermediate frequency signal outputted from the front end 2 is supplied to an intermediate frequency amplifier 4 through a SAW filter 3 as an IF filter. The intermediate frequency signal amplified in the intermediate frequency amplifier 4 is converted from an analog signal into digital data in an A/C converter 5, and the digital data are supplied to an orthogonal demodulator 6.

The orthogonal demodulator 6 is formed of, for example, two mixers, a local oscillator and a phase shifter. One mixer mixes an oscillation signal outputted from the local oscillator and an intermediate frequency so as to output an in-phase component signal I of a base band signal. The other mixer mixes a signal obtained by subjecting the oscillation signal outputted from the local oscillator to 90° phase shifting in the phase shifter, and the intermediate frequency so as to output an orthogonal component signal Q of a base band signal. The in-phase and orthogonal component signals I, Q thus obtained are supplied to FFT 7 (Fast Fourier Transformer).

The FFT 7 is a device for analyzing frequency components, and adapted to subject in-phase and orthogonal component signals I, Q of digital data supplied to fast Fourier transformation, and thereby convert these signals from signals on a time axis into those on a frequency axis. This conversion is carried out by taking out data by applying a FFT window signal to a transmission mode in a predetermined period of time of digital data to be Fourier converted in accordance with a control signal from a system control unit 16. The phase information (in, qn) on carriers taken out is supplied to a differential demodulator 8.

The differential demodulator 8 carries out a differential demodulation operation on the basis of phase information concerning the n-pieces of carriers. In the differential demodulation operation, a phase difference between preceding phase information and present phase information is determined by carrying out for every carrier the multiplication of conjugate complex numbers of phase information on input preceding symbols and phase information on present symbols. An output signal from the differential demodulator 8 bearing the phase difference information on each carrier thus determined is defined as a data array signal of seemingly most accurate value by a viterbi decoder 9. The defined data array signal is sent out to a sound decoder 10. The sound decoder 10 solves the sound compression of the data array signal from the viterbi decoder 9, and outputs the results as PCM (Pulse Code Modulation) digital audio data to a sound reproduction system including a D/A converter (not shown) on a later stage. A processing operation on stages after the demodulator 8 may be carried out by constitution including the releasing of interleaving and the correction of errors.

An output signal from the orthogonal demodulator 6 is supplied to a NULL detector 11. The NULL detector 11 detects a no-signal section of a transmission frame shown in Fig. 1A in accordance with the in-phase and orthogonal component signals I, Q obtained from the orthogonal demodulator 6, and supplies a signal from the NULL detector to the system control unit 16. The NULL detector 11 detects the existence and non-existence of NULL symbols in the transmission frame, and outputs "L" or "H". To be more exact, the NULL detector 11 outputs a signal which is "L" at a NULL symbol portion only as shown in Fig. 1C, in a transmission signal as shown in Fig. 1B, to the system control unit 16. The system control unit 16 determines on the basis of this signal a NULL symbol length Td and a frame length Tf, compares these lengths with a NULL symbol length Td and a frame length Tf in each transmission mode prescribed in a DAB system shown in Fig. 2, and determines a transmission mode of a radio wave which is being received. The system control unit 16 also selects a FFT window signal corresponding to the determined transmission mode, controls (AFC) a reception frequency automatically, and synchronizes a sampling frequency of an A/D converter accurately with an input signal.

An output signal from FFT 7 is supplied to a carrier detector 12 as detecting means. The carrier detector 12 detects a frequency of a signal subjected to FFT and its signal level, which are supplied to a RAM 13 as storage means. The RAM 13 has a storage region in which correction data necessary for various correction means which will be described later are stored. An arithmetic processing unit 14 as arithmetic means calculates a correction value required to correct a transmitter identification information TII on the basis of the correction data in the RAM 13. A correction processing unit 15 corrects a signal level of each carrier of a transmitter identification information TII received in accordance with a correction value and a difference value supplied from the arithmetic processing unit 14. The system control unit 16 is formed of, for example, a microcomputer, and controls as mentioned above the judgement of a transmission mode using NULL symbols supplied from the NULL detector 11; the FFT 7 and differential demodulator 8 in accordance with the transmission mode judgement results; and other circuits. Although the carrier detector 12, arithmetic processing unit 14 and correction processing unit 15 are described as separate circuit blocks, they may also be incorporated into the system control unit 16, or formed of a combination of the system control unit 16 and a digital signal processor (DSP).

The receiver 50 for digital broadcasting according to the present invention corrects accurately a reception level of a transmitter identification information TII distorted due to the frequency characteristics of a transmission system or a SAW filter. Regarding the matter, concrete means for correcting a level of a transmitter identification information TII to a proper signal level will be described below.

The concrete means referred to above, for correcting a level of a transmitter identification information TII to a proper reception level is, strictly speaking, means for correcting a reception level of the carriers existing in bit groups, which constitute the transmitter identification information TII, to a proper signal level. Namely, correcting carriers is equivalent to correcting bit groups and correcting transmitter identification information TII. Therefore, the correction of a transmitter identification information TII will be described as an operation equivalent to the correction of bit groups and the correction of carriers.

(1) Correction based on the frequency characteristics of a SAW filter:

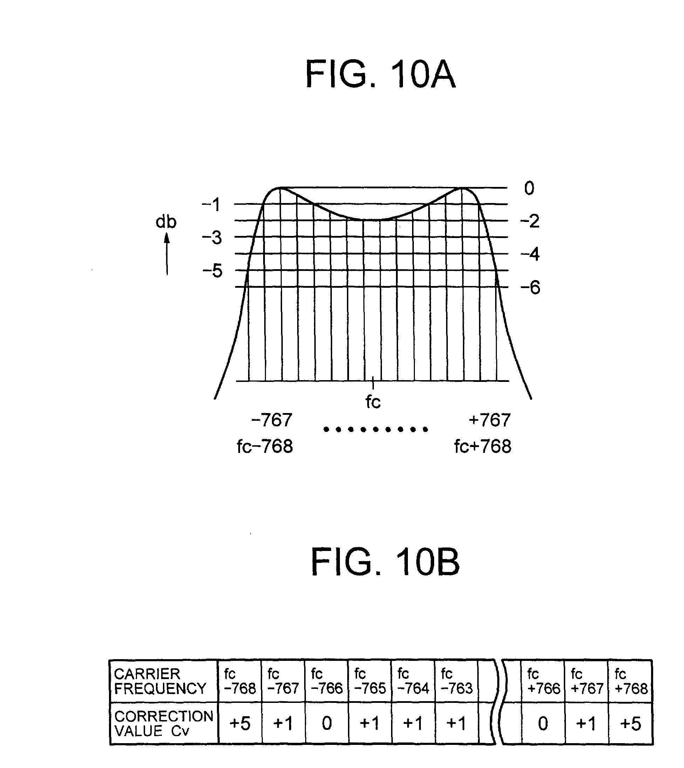

Fig. 10A schematically shows the frequency characteristic of a SAW filter 3, in which the frequency characteristic is divided into 1536 equal parts in accordance with carrier frequencies of a transmission signal. Fig. 10B shows correction values Cv necessary for the correction of an attenuation amount of each carrier frequency of the SAW filter 3.

Referring to Fig. 10A, an amount of the attenuation of a maximum portion of the frequency characteristic is set as a reference level, for example, 0 db, and an attenuation amount based on the reference level can be determined with respect to carrier frequencies corresponding to 1536 portions. For example, when an attenuation amount at a carrier frequency corresponding to fc-768 is -5 db, a correction value Cv at a carrier frequency thereof becomes digital data corresponding to +5 db as shown in Fig. 10B. When an attenuation amount at a carrier frequency corresponding to fc-767 is -1 db, a correction value Cv at a carrier frequency thereof becomes digital data corresponding to +1 db.

The correction values Cv (1536 each) with respect to the carrier frequencies of the SAW filter 3 may be stored in advance as frequency characteristics setting values for the SAW filter 3 in a correction value storage region of the RAM 13 at the time of designing the receiver 50 for digital broadcasting. The correction values Cv with respect to the carrier frequencies of the SAW filter 3 may also be stored automatically in the correction value storage region by using a reference single generator adapted to generate a transmitter identification information TII formed falsely at the time of regulating the receiver 50 for digital broadcasting.

The receiver 50 for digital broadcasting ascertains the regulation of a reception frequency and an operation of each function by using a reference signal generator. During this time, the receiver uses at the same amplitude a transmitter identification information TII, which is falsely formed at 1536 carrier frequencies, as a modulation signal; receives this signal; automatically calculates correction values Cv on the basis of a signal level at each carrier frequency of each carrier which has passed through the SAW filter 3; and stores digital data for the correction values Cv in the correction value storage region. In any case, 1536 correction values Cv with respect to the frequency characteristic of the SAW filter 3 shall be stored for respective carrier frequencies in the correction value storage region of the RAM 13 of the receiver 50 for digital broadcasting. A mode 1 having the largest number of carrier frequencies includes the carrier frequencies in modes 2, 3 and 4 as well. Therefore, when correction values Cv are stored correspondingly to the 1536 carrier frequencies in the mode 1, the receiver can be applied to all the modes.

A concrete operation in the mode 1 as an example for carrying out a correction operation based on the frequency characteristic of the SAW filter will now be described.

When a transmission mode is defined in the system control unit 16 in accordance with an output signal from the NULL detector 11, an FFT window optimum for a transmission mode is given, and in-phase and orthogonal component signals I, Q of a transmitter identification information TII outputted from the FFT 7 are supplied to the carrier detector 12. The carrier detector 12 detects in order the signal levels at each carrier frequency of fc-768 to fc+768 of the transmitter identification information TII, and stores the signal levels correspondingly to carrier frequencies in a TII signal level storage region of the RAM 13.

The arithmetic processing unit 14 reads out in order the signal level at each carrier frequency of the transmitter identification information TII, which is detected by the carrier detector 12, from the TII signal level storage region, and then the correction values Cv, which are stored in the correction storage region corresponding to the carrier frequencies added to the signal levels, on the basis of the carrier frequencies, the digital data on the signal levels and those on the correction values Cv being supplied to the correction processing unit 15. The correction processing unit 15 corrects by a correction value Cv a signal level at each carrier frequency of the transmitter identification information TII. The corrected signal levels at the respective carrier frequencies are stored in order again in the TII signal level storage region. Owing to the execution of such a correction operation, the receiver 50 for digital broadcasting enables the signal levels at the respective carrier frequencies of the transmitter identification information TII attenuated due to the frequency characteristic of the SAW filter 3 to be corrected to the levels at which the signals had been positioned before they passed through the SAW filter.

(2) Correction using reference symbols:

The correction mentioned above of the frequency characteristic of the SAW filter 3 is the correction of a transmission passage in the interior of the receiver 50 for digital broadcasting. However, when distortion and attenuation occur in a part of a transmission frame due to, for example, a fading phenomenon in a transmission space between a transmitter T and the receiver 50 for digital broadcasting, a correction operation cannot be carried out by the above method.

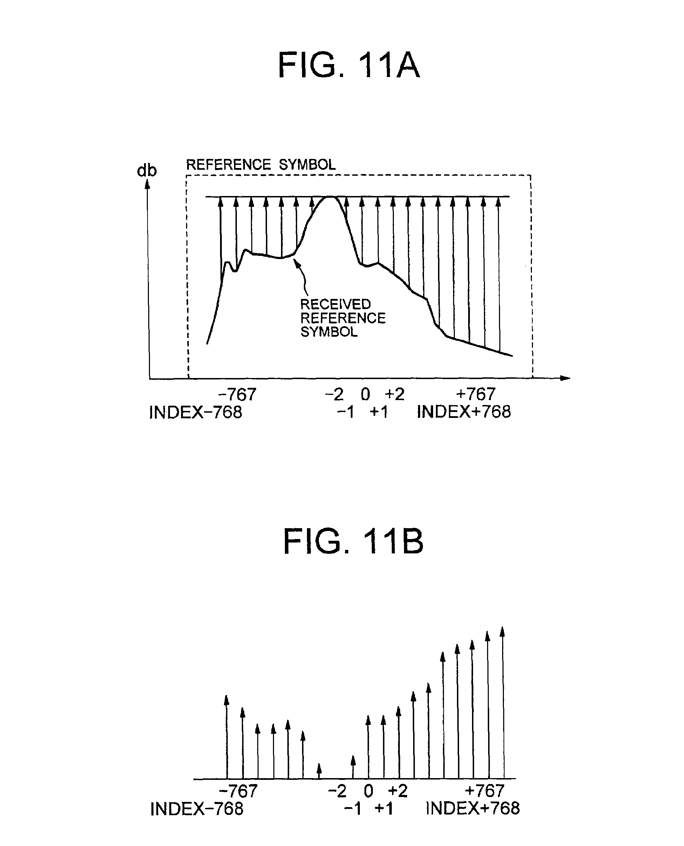

In view of the above, a method of correcting a transmitter identification information TII by using reference symbols bearing information already known to the receiver will now be described with reference to Figs. 11A and 11B.

In a transmission frame, all symbols except NULL symbols are transmitted with the same amplitude. As shown in Fig. 1, a NULL symbol and a reference symbol are adjacent to each other with respect to time, and the frequency characteristics of the NULL symbols and reference symbols in the spatial transmission passage between the transmitter T and receiver 50 for digital broadcasting can be regarded substantially identical. Namely, it is possible to judge that, when distortion occurs in any carrier frequency of the carriers included in the NULL symbols and constituting the transmitter identification information TII, similar distortion also occurs in a carrier frequency of the same reference symbols. Therefore, in the receiver 50 for digital broadcasting according to the present invention, a distortion amount of signal level for each index number of the received reference symbols is determined in advance, and a signal level is corrected to a proper level by adding the distortion amount to a reception level of the same index number in the transmitter identification information TII.

A concrete operation for correcting a reception level of each carrier of the transmitter identification information TII by reference symbols will now be described. A received reference symbol will hereafter be described as a reference symbol distorted as shown in Fig. 11A.

When a transmission mode is defined in accordance with an output signal from the NULL detector 11 in the receiver 50 for digital broadcasting, an FFT window optimum for a transmission mode is given, and a transmitter identification information TII outputted from the FFT 7 and reference symbols are supplied to the carrier detector 12. In the carrier detector 12, the transmitter identification information TII and reference symbols are represented by index numbers and arranged in Index $0\pm768$. Therefore, the signal level of the transmitter identification information TII and that of reference symbols are detected in order correspondingly to each index number, and stored in the TII signal level storage region and reference level storage region of the RAM 13 correspondingly to the index numbers.

The arithmetic processing unit 14 is adapted to calculate for each index number a difference value Dr with respect to a maximum value of a reference symbol as shown in Fig. 11B, on the basis of signal levels of reference symbols stored in the reference level storage region, supply the difference value Dr to the correction processing unit 15, and supply the signal level of the transmitter identification information TII stored in the TII signal level storage region of the RAM to the correction processing unit 15,

The correction processing unit 15 corrects the signal levels of the transmitter identification information TII for each index number by a differential value Dr of a corresponding index number. The corrected signal level of each carrier is stored again in order in the TII signal level storage region. Such a correction operation is carried out. Accordingly, when distortion occurs in a part of a transmission frame due to the influence of a fading phenomenon in a transmission space between the transmitter T and receiver 50 for digital broadcasting, a correction operation can be carried out with respect to each carrier of the transmitter identification information TII by utilizing a reference symbol adjacent thereto with respect to the time, and a proper signal level of the transmitter identification information TII can be obtained in a short period of time.

(3) Correction based on an average using a plurality of bit groups:

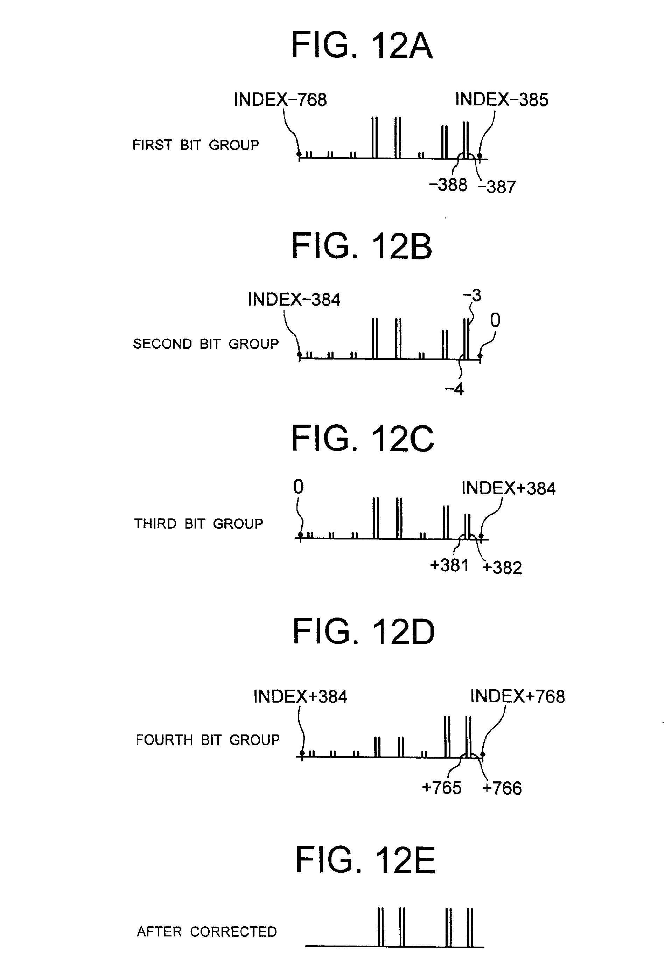

A method of correcting a signal level of received transmitter identification information TII by determining an average of signal levels of carriers constituting a bit group will now be described by using Fig. 12.

As mentioned above, in the transmitter identification information TII of the mode 1, four bit groups of the same content are transmitted, and the mode 4 is formed of two bit groups of the same content. Moreover, the signal level of each bit group is also outputted at the same level from the transmitter T. The bit groups have mutually different frequency bands. Therefore, even when distortion should occur in the frequency band of one bit group, distortion does not necessarily occur in the same manner in the frequency band of another bit group.

Therefore, when the receiver 50 for digital broadcasting judges that the signal TII is in the mode 1, in accordance with an output signal from the NULL detector 11, the signal level of the transmitter identification information TII can be corrected as shown in Fig. 12E by determining averages of amplitude of the carriers in the same positional relation in four bit groups of the same content, i.e. a first bit group (Fig. 12A) of index-768~index-385, a second bit group (Fig. 12B) of index-384~index-1, a third bit group (Fig. 12C) of index1~index384 and a fourth bit group (Fig. 12D) of index385~index768.

For example, the carrier pairs of index-388 and index-387 in the first bit group, index-4 and index-3 in the second bit group, index+381 and index+382 in the third bit group and index+765 and index+766 in the fourth bit group are carriers in the same positional relation.

To be more exact, the arithmetic processing unit 14 accesses the RAM 13 and obtains, for example, the carrier pair of index-388 and index-387 in the first bit group, the carrier pair of index-4 and index-3 in the second bit group, the carrier pair of index+381 and index+382 in the third bit group, and the carrier pair of index+765 and index+766 in the fourth bit group shown in Figs. 12A-12D, from the signal levels of the carriers of the transmitter identification information TII stored in the TII signal level storage region thereof; sums up the carrier pairs bearing the same information; divides the resultant value by four; and sets the resultant value as an average amplitude value (Fig. 12E) of one carrier pair. This average amplitude value is stored in the bit group storage region of the RAM 13. The same arithmetic processing operation is carried out for each of the other carrier pairs, and the resultant values are stored in the RAM 13.

In the case of the mode 4, the reception level of the transmitter identification information TII can be corrected properly in the same manner as in the case of the mode 1 by subjecting the first and second bit groups shown in Fig. 7 to an arithmetic processing operation. Owing to such operations, even when one-sided distortion occurs in a frequency band, a signal level of the transmitter identification information TII in a bit group influenced by the distortion and that of the transmitter identification information TII in a bit group not influenced by the distortion are averaged, so that the influence due to the distortion can be alleviated.

(4) Correction based on an average of signal levels of carriers in a bit group:

An averaging method using eight carriers constituting a bit group will now be described.

A signal level of carriers in one bit is expressed by the following equation (3).

Signal level of a bit:

$$bit[b, c]=index[48b+2c]+index[48b+2c+1] \qquad (3)$$

The b represents the number of a bit, and c a sub-identification signal. The index[48b+2c] represents a signal level of carriers in the case of the index number of 48b+2c, and the index[48b+2c+1] a signal level of carriers in the case of the index number of 48b+2c+1, these two being summed up to determine a signal level of a carrier pair constituting one bit.

An average (power) of signal levels of a bit group is expressed by the following equation (4).

$$Power = \sum_{b=0}^{7} \frac{bit[b,c] \times a_b(p)}{4} \quad ...(4)$$

when c=0, p=0,

$$Power = \frac{bit[0,0] \times a_0(0) + \cdots + bit[0,7] \times a_7(0)}{4}$$
$$= \frac{0 \times 0 + 0 \times 0 + 0 \times 0 + 0 \times 0 + 9 \times 1 + 8 \times 1 + 9 \times 1 + 10 \times 1}{4}$$
$$= 9$$

wherein $a_b$ (p) represents a bit pattern of a bit group shown in Fig. 4. For example, in the case of a main identification signal of p=0, $a_b(0)$= "00001111" .

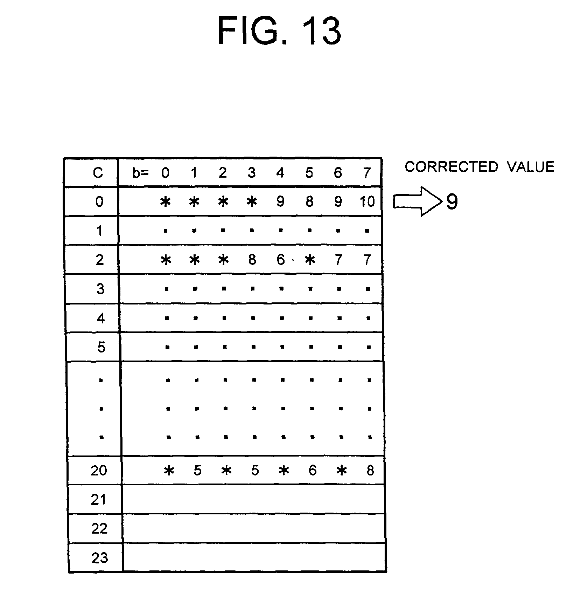

Therefore, in order to determine an average of signal levels of bit groups by the above equation (4), it is necessary to determine a main identification signal and a sub-identification signal. A description will be given by taking a case shown in Fig. 13 as an example. The numerals represent signal levels of bits, and a mark [2*] low noise.

When c=0 in the table of Fig. 13 with the mark "*" and a numeral of not smaller than 5 is judged to be "0" and "1 " respectively, a bit pattern becomes "00001111" , and it is understood that this bit pattern corresponds to the bit pattern of P=0 shown in Fig. 4. Namely, a signal level of each corresponding bit for every sub-identification information value (c) is detected in order, and a bit pattern is determined by "0" and "1" for every sub-identification signal, whereby main identification information is obtained.

A signal level of the transmitter identification information TII is determined by summing up the amplitudes of carriers of bit groups obtained. However, since a bit group having eight bits contains noise as mentioned above, an average value (Power) of a bit group is calculated in accordance with the equation (4).

For example, a case of c=0 in the table of Fig. 13 will be described as an example. When each eight-bit carrier of a transmitter identification information TII obtained is multiplied by a corresponding bit pattern (p=00001111), the noise of a mark "*" is converted into "0", and signal levels other than this are outputted as they are. Accordingly, when a total of carriers is reduced to 1/4,an average value of signal levels of a transmitter identification information TII is accurately calculated.

(5) Correction based on the averaging of the time of a bit group:

The above is a description of a method of correcting a signal level of transmitter identification information TII included in NULL symbols constituting one transmission frame to a proper signal level. Such a correction may also be made by detecting transmitter identification information TII in a plurality of transmission frames, determining an average of a plurality of bit groups, and using the resultant average as a signal level of the transmitter identification information TII. In the DAB broadcasting, a transmission frame is transmitted at all times. Therefore, when a judgement that detected transmitter identification information TII includes a lot of distortion is given, repeatedly received transmission frames are detected for a predetermined period of time, and a plurality of bit groups obtained are averaged. This enables a highly accurate reception level of the transmitter identification information TII to be obtained.

Owing to these operations, even when a large distortion occurs momentarily in a transmitter identification information TII, it is averaged with respect to the time, so that the influence of the distortion can be alleviated greatly. Furthermore, since only the information on the carriers constituting the transmitter identification information TII is stored, the quantity of past data corresponding to a predetermined period of time stored in the RAM 13 can be reduced.

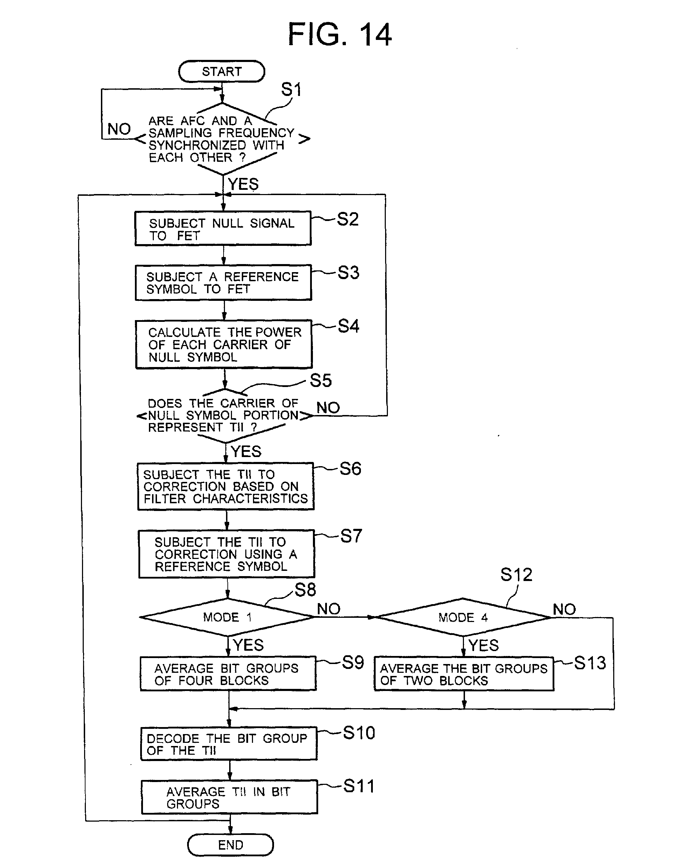

The case where the above-described correction operations are carried out as a series of operations of the receiver 50 for digital broadcasting will now be described with reference to Figs. 9 and 14. A ROM 17 stores therein, in advance, a program for starting the following operations on the basis of a user's operation of a controlling portion (not shown).

When, for example, a reception frequency of the receiver 50 for digital broadcasting is set by an operator s operation, the front end 2 receives a desired radio wave. The radio wave received is converted at the front end 2 into an intermediate frequency, which is then outputted therefrom. The converted intermediate frequency passes through the SAW filter 3, an IF filter, and is then amplified by the intermediate frequency amplifier 4. The resultant frequency is converted from an analog signal into a digital data by the A/D converter 5, and the digital data are supplied to the orthogonal demodulator 6.

The differential demodulator 8 is adapted to carry out a differential demodulation operation on the basis of phase information concerning the carriers of a transmission frame, and supply in-phase and orthogonal component signals I, Q to the FFT 7 and NULL detector 11. The NULL detector 11 is adapted to determine a transmission mode on the basis of a falling time length (Td) and cycle (Tf) of a NULL symbol portion, and supply a NULL detected signal to the system control unit 16. The system control unit 16 is adapted to set a window position of the FFT 7 corresponding to the transmission mode.

The system control unit 16 monitors the synchronization of AFC and sampling frequency with each other in Step S1 as shown in Fig. 14. When the synchronization is not attained (NO), the system control unit 16 continues the monitoring operation. When the synchronization is attained (YES), the system control unit 16 advances its operation to Step S2.

In Step S2, the system control unit 16 subjects a NULL signal to fast Fourier conversion by controlling the FFT, and supplies the resultant output signal to the carrier detector 12. The carrier detector 12 detects a signal level of each carrier of a NULL symbol portion outputted from the FFT 7, and stores the signal levels in the TII signal level storage region of the RAM 13. The system control unit 16 then advances its operation to Step S3, sets a window position to a reference symbol, subjects the reference symbol to fast Fourier conversion by controlling the FFT 7, and supplies the resultant output signal to the carrier detector 12. The carrier detector 12 detects a level of each carrier of a reference symbol outputted from the FFT 7, and stores the detected levels in the reference level storage region of the RAM 13.22222222222

The system control unit 16 then advances its operation to Step S4, calculates the power on the basis of the amplitude of each carrier of the NULL symbols stored in the TII signal level storage region of the RAM 13, and advances its operation to Step S5. In the Step S5, the system control unit 16 judges from the calculation results whether the carrier of the NULL symbols is a signal representing the transmitter identification information TII or not. When a judgement that the carrier represents the transmitter identification information TII cannot be given (NO) in the Step S5, the operation is advanced to Step S2 to repeatedly follow the procedures to be taken in Steps S2 onward. When a judgement that the carrier represents the transmitter identification information TII is given in Step S5, the operation is advanced to Step S6.

In the Step S6, the system control unit 16 carries out a correction operation, which is referred to (1) above and based on the frequency characteristic of the SAW filter, is carried out with respect to the received transmitter identification information TII. The operation is then advanced to Step S7 to make corrections, which are referred to (2) above, on the transmitter identification information TII on the basis of the reference symbols. The system control unit 16 then advances its operation to Step S8, and judges whether the detected transmission mode is the transmission mode 1. When a judgement that the detected transmission mode is the transmission mode 1 is given (YES), the operation is advanced to Step S9. The system control unit 16 subjects the bit groups in the four blocks of the transmitter identification information TII to correction in accordance with the above-mentioned (3) correction based on an average of a plurality of bit groups, and advances its operation to Step S10.

In Step S10, the bit groups of the transmitter identification information TII are decoded. The main identification information and sub-identification information which are contained in the transmitter identification information TII are supplied to the system control unit 16. The system control unit 16 displays main identification information and sub-identification information on a display unit as necessary. The operation is then advanced to Step S11, in which a correction operation based on an average of signal levels of carriers in a bit group mentioned in (4) above is carried out, an average signal level of the transmitter identification information TII being calculated, a transmitter identification information TII corrected to a proper signal level being then supplied to the system control unit 16 to complete a series of operations. Owing to these operations, the system control unit 16 can always obtain a transmitter identification information TII corrected to a proper level.

When a judgement is given that the actual transmission mode is not the transmission mode 1 (NO) in Step S8, the operation is advanced to Step S12.

When a judgement is given that the actual transmission mode is not the transmission mode 4 (NO) in Step S12, the operation is advanced to Step S10, and Step S11 onward are carried out. When a judgement is given that the actual transmission mode is the transmission mode 4 (YES) in Step S12, the operation is advanced to Step S13, in which the system control unit 16 makes corrections, which are based on the above-mentioned (3) average of a plurality of bit groups, on bit groups in two blocks of the transmitter identification information TII. The operation is advanced to Step S10, and the Steps S10 onward are carried out.

As described above, in the embodiment of the receiver 50 for digital broadcasting according to the present invention, the use of a combination of a plurality of correction methods enables a correction operation adaptable to various types of distortion due to the transmission system to be carried out more effectively than the independent use of each of the above-mentioned various kinds of correction methods.

The correction method (1) based on the frequency characteristic of the SAW filter may also be constituted so as to detect a signal level of only a carrier frequency in which carriers exist, and carry out a correction operation without making corrections on a carrier frequency in which carriers do not exist. When the carriers of transmitter identification information TII which is desired to be corrected are known in advance, a correction method may be constituted so that a signal level of only a carrier frequency in which such carriers exist is detected with a correction operation then carried out. Owing to such correction methods, it becomes unnecessary to store a carrier frequency not required to be corrected, and detect a signal level of such a carrier frequency, and it becomes possible to greatly reduce the storage capacity of the TII signal level storage region, and the length of time required to carry out a correction operation.

The correction method (2) using reference symbols may also be constituted so as to detect a signal level of only an index number in which carriers exist, and correct the signal level thereof without making corrections on an index number in which carriers do not exist. When the carriers of a transmitter identification information TII desired to be corrected are known in advance, the correction method may be constituted so as to selectively detect the signal level only of the index number in which carriers exist, and then correct the signal level. Owing to these methods, it becomes unnecessary to store an index number not requiring to be corrected, and detect a signal level, and it becomes possible to greatly reduce the storage capacity of the TII signal level storage region, and the length of time required to carry out a correction operation.

In order to determine a difference value Dr for every index number in the correction method (2) using reference symbols, the method may be constituted so as to determine a difference value with respect to a signal level which becomes known in a case where reference symbols are received in a stable condition, and not so as to determine a difference value with respect to a maximum value of the received reference symbols.

When the carriers of a transmitter identification information TII which is desired to be corrected are known in advance in the correction method (3) based on an average of a plurality of bit groups, the correction method (4) based on an average of signal levels of carriers in a bit group, and the correction method (5) based on the averaging of the time of a bit group, the methods may be constituted so as to selectively detect only the signal level of an index number in which the carriers exist, and then correct the signal level. Owing to these methods, it becomes unnecessary to store a carrier frequency not requiring to be corrected, and detect a signal level of such a carrier frequency, and it becomes possible to greatly reduce the storage capacity of the TII signal level storage region, and the length of time required to carry out a correction operation.

In the correction method (3) based on an average of a plurality of bit groups, the correction method (4) based on an average of signal levels of carriers in a bit group, and the correction method (5) based on the averaging of the time of a bit group, the signal level of a transmitter identification information TII is corrected on the basis of an average value of the signal levels of the carriers forming a bit group. These methods may also be constituted so as to correct the signal level of a transmitter identification information TII on the basis of a maximum value of the signal levels of the carriers forming a bit group.

The correction operation (5) based on the averaging of the time of a bit group may be inserted after Step S11 of Fig. 14. To be more exact, the correction operation is completed in Step S11 according to the flow of operation shown in Fig. 14. The correction method may also be constituted so as to advance the operation to Step S2 again after the Step S11 is carried out, detect the signal level of the transmitter identification information TII corresponding to a plurality of transmission frames and store the same, and then carry out a correction operation.

The case where a plurality of correction device are provided is described in Fig. 14. A combination of correction devices is not limited to that used in this case.

According to the present invention described above, the signal level of transmitter identification information TII distorted due to the influence of a transmission passage can be corrected to a signal level which the TII possessed before the distortion occurred therein due to the influence of the transmission passage, by using various kinds of correction values, such as an attenuation amount owing to the use of a SAW filter. When the carriers of transmitter identification information TII desired to be corrected in advance are known, a correction operation is carried out by selectively detecting only a signal level of an index number in which the carriers exist. Accordingly, it becomes unnecessary to carry out the storing and detecting of a signal level not requiring to be corrected of an index number, and it becomes possible to greatly reduce the storage capacity and the length of the time required to carry out a correction operation. Therefore, in order to carry out a processing operation utilizing the signal level of a transmitter identification information TII, more accurate signal level can be obtained, and the accuracy of the processing operation can be improved to a great extent. For example, when the signal level of a transmitter identification information TII transmitted from the transistor T is already known, it can be conceived that a distance between the transmitter T and receiver be estimated on the basis of an attenuation amount of the signal level by comparing with each other the signal level at the transmission time and that of the transmitter identification information TII at the time of reception thereof at the receiver.

## Claims

1. A receiver for receiving a digital broadcasting signal having a frame structure which is modulated with an OFDM (Orthogonal Frequency Division Multiplexer) system, the frame including a plurality of symbols each of which includes a plurality of carriers in a predetermined frequency band, the frame further including at a beginning portion thereof frame starting information indicative of the starting of the frame, the frame starting information including a symbol having auxiliary data which is necessary for reception, comprising:
   correction means for correcting a carrier signal level of the symbol having the auxiliary data.

2. A receiver according to Claim 1, wherein the receiver includes storage means for storing an attenuation amount of the carrier signal which is attenuated due to the filtering characteristic of an IF (Intermediate Frequency) filter,
   said correction means corrects the carrier signal level on the basis of data of the attenuation amount stored in said storage means.

3. A receiver according to Claim 1, wherein the receiver includes detection means for detecting the carrier signal level of a symbol which is adjacent to a symbol having the auxiliary data with respect to time,
   said correction means corrects the carrier signal level on the basis of a maximum value of the detected signal level by said detection means and a carrier signal level of the same frequency as a carrier signal to be corrected.

4. A receiver according to Claim 1, wherein, the symbol having the auxiliary data includes a plurality of bit groups of the same content and the auxiliary data represents a bit group having a plurality of carrier signals, the receiver includes:

   detection means for detecting a level of each carrier signal constituting the bit group, and
   arithmetic means for calculating an average of signal levels of the same bits in a plurality of bit groups the basis of the detected results by said detection means,
said correction means corrects the carrier signal level on the basis of the results of the arithmetic operation by said arithmetic means.

5.  A receiver according to Claim 1, wherein, the auxiliary data represents a bit group having a plurality of carrier signals, the receiver includes:

detection means for detecting a level of each carrier signal constituting the bit group, and
arithmetic means for calculating an average of signal levels of the bit group on the basis of the detected results of said detection means,
said correction means corrects the carrier signal level on the basis of the results of the arithmetic operation by said arithmetic means.

6.  A receiver according to Claim 1, wherein, the auxiliary data represents a bit group having a plurality of carrier signals, the receiver includes:

detection means for detecting a level of each carrier signal constituting the bit group, and
arithmetic means for calculating an average of the signal levels of bit groups corresponding to a predetermined period of time on the basis of the detected results of said detection means,
said correction means corrects the carrier signal level on the basis of the results of the arithmetic operation by said arithmetic means.

1 TRANSMISSION FRAME (96ms, MODE 1)

| Sync | | FIC | | MSC |

**FIG. 1A**

| NULL (TII) | S=1 | 2 | 3 | 4 | 5 | | 75 | 76 |

EFFECTIVE SYMBOL

GUARD INTERVAL

NULL SYMBOL

REFERENCE SYMBOL

DATA SYMBOL

**FIG. 1B**

**FIG. 1C**

$T_d$

$T_f$

EP 1 117 178 A2

# FIG. 2

| | MODE 1 | MODE 2 | MODE 3 | MODE 4 |
|---|---|---|---|---|
| NUMBER OF SYMBOLS | 76 | 76 | 158 | 76 |
| NUMBER OF CARRIERS | 1536 | 384 | 192 | 768 |
| CARRIER SPACE | 1 kHz | 4 kHz | 8 kHz | 2 kHz |
| FRAME LENGTH (Tf) | 96 ms | 24 ms | 24 ms | 48 ms |
| NULL SYMBOL LENGTH (Td) | 1.297 ms | 324 $\mu$s | 168 $\mu$s | 648 $\mu$s |
| SYMBOL LENGTH | 1.246 ms | 312 $\mu$s | 158 $\mu$s | 823 $\mu$s |
| EFFECTIVE SYMBOL LENGTH | 1 ms | 250 $\mu$s | 125 $\mu$s | 500 $\mu$s |
| GUARD INTERVAL | 246 ms | 62 $\mu$s | 31 $\mu$s | 123 $\mu$s |

EP 1 117 178 A2

# FIG. 3

# FIG. 4

| P | b=0 | 1 | 2 | 3 | 4 | 5 | 6 | 7 |
|---|---|---|---|---|---|---|---|---|
| 0 | 0 | 0 | 0 | 0 | 1 | 1 | 1 | 1 |
| 1 | 0 | 0 | 0 | 1 | 0 | 1 | 1 | 1 |
| 2 | 0 | 0 | 0 | 1 | 1 | 0 | 1 | 1 |
| 3 | 0 | 0 | 0 | 1 | 1 | 1 | 0 | 1 |
| 4 | 0 | 0 | 0 | 1 | 1 | 1 | 1 | 0 |
| 5 | 0 | 0 | 0 | 1 | 0 | 1 | 1 | 1 |
| 6 | 0 | 0 | 1 | 0 | 1 | 0 | 1 | 1 |
| 7 | 0 | 0 | 1 | 0 | 0 | 1 | 0 | 1 |
| 8 | 0 | 0 | 1 | 0 | 1 | 1 | 1 | 1 |
| 9 | 0 | 0 | 1 | 0 | 0 | 0 | 1 | 0 |
| 10 | 0 | 0 | 1 | 0 | 0 | 1 | 0 | 1 |
| 11 | 0 | 0 | 1 | 1 | 0 | 1 | 1 | 0 |
| 12 | 0 | 0 | 1 | 1 | 1 | 0 | 0 | 1 |
| 13 | 0 | 0 | 1 | 1 | 1 | 1 | 1 | 0 |
| 14 | 0 | 0 | 1 | 1 | 0 | 1 | 0 | 0 |
| 15 | 0 | 0 | 1 | 0 | 1 | 1 | 1 | 1 |
| 16 | 0 | 0 | 1 | 0 | 1 | 0 | 1 | 1 |
| 17 | 0 | 1 | 0 | 0 | 1 | 1 | 0 | 0 |
| 18 | 0 | 1 | 0 | 0 | 1 | 1 | 1 | 1 |
| 19 | 0 | 1 | 0 | 0 | 0 | 0 | 0 | 1 |
| 20 | 0 | 1 | 0 | 1 | 0 | 1 | 1 | 1 |
| 21 | 0 | 1 | 0 | 1 | 1 | 1 | 0 | 0 |
| 22 | 0 | 1 | 0 | 1 | 1 | 0 | 1 | 1 |
| 23 | 0 | 1 | 0 | 1 | 1 | 0 | 1 | 0 |

| P | b=0 | 1 | 2 | 3 | 4 | 5 | 6 | 7 |
|---|---|---|---|---|---|---|---|---|
| 24 | 0 | 1 | 0 | 1 | 1 | 1 | 0 | 0 |
| 25 | 0 | 1 | 1 | 0 | 0 | 0 | 1 | 1 |
| 26 | 0 | 1 | 1 | 1 | 0 | 1 | 0 | 1 |
| 27 | 0 | 1 | 1 | 0 | 0 | 1 | 1 | 0 |
| 28 | 0 | 1 | 1 | 0 | 1 | 0 | 1 | 1 |
| 29 | 0 | 1 | 1 | 0 | 1 | 0 | 0 | 0 |
| 30 | 0 | 1 | 1 | 0 | 1 | 0 | 1 | 0 |
| 31 | 0 | 1 | 1 | 1 | 0 | 1 | 0 | 1 |
| 32 | 0 | 1 | 1 | 1 | 0 | 0 | 0 | 0 |
| 33 | 0 | 1 | 1 | 1 | 0 | 1 | 1 | 0 |
| 34 | 1 | 1 | 1 | 0 | 1 | 0 | 1 | 0 |
| 35 | 1 | 0 | 1 | 0 | 0 | 1 | 1 | 1 |
| 36 | 1 | 0 | 1 | 0 | 1 | 0 | 0 | 1 |
| 37 | 1 | 0 | 1 | 1 | 1 | 1 | 1 | 1 |
| 38 | 1 | 0 | 1 | 1 | 1 | 0 | 0 | 0 |
| 39 | 1 | 0 | 1 | 1 | 0 | 1 | 1 | 1 |
| 40 | 1 | 0 | 1 | 1 | 0 | 0 | 0 | 0 |
| 41 | 1 | 0 | 1 | 1 | 0 | 1 | 1 | 1 |
| 42 | 1 | 0 | 1 | 1 | 0 | 0 | 0 | 0 |
| 43 | 1 | 0 | 1 | 1 | 1 | 1 | 1 | 0 |
| 44 | 1 | 0 | 1 | 0 | 0 | 0 | 0 | 1 |
| 45 | 1 | 0 | 1 | 0 | 0 | 1 | 1 | 1 |
| 46 | 1 | 0 | 1 | 0 | 0 | 0 | 0 | 1 |
| 47 | 1 | 0 | 1 | 0 | 0 | 1 | 1 | 0 |

| P | b=0 | 1 | 2 | 3 | 4 | 5 | 6 | 7 |
|---|---|---|---|---|---|---|---|---|
| 48 | 1 | 0 | 0 | 0 | 1 | 0 | 0 | 1 |
| 49 | 1 | 0 | 0 | 0 | 1 | 0 | 1 | 0 |
| 50 | 1 | 0 | 1 | 0 | 1 | 0 | 0 | 0 |
| 51 | 1 | 0 | 0 | 1 | 0 | 0 | 0 | 1 |
| 52 | 1 | 0 | 0 | 1 | 1 | 0 | 1 | 0 |
| 53 | 1 | 0 | 0 | 1 | 0 | 1 | 0 | 0 |
| 54 | 1 | 0 | 1 | 0 | 1 | 0 | 0 | 0 |
| 55 | 1 | 0 | 1 | 0 | 0 | 1 | 1 | 1 |
| 56 | 1 | 1 | 0 | 0 | 1 | 1 | 0 | 1 |
| 57 | 1 | 1 | 0 | 0 | 1 | 0 | 1 | 1 |
| 58 | 1 | 1 | 0 | 0 | 0 | 0 | 0 | 0 |
| 59 | 1 | 1 | 0 | 0 | 1 | 1 | 1 | 1 |
| 60 | 1 | 1 | 0 | 0 | 0 | 0 | 0 | 0 |
| 61 | 1 | 1 | 0 | 1 | 1 | 1 | 0 | 0 |
| 62 | 1 | 1 | 0 | 1 | 0 | 0 | 1 | 1 |
| 63 | 1 | 1 | 1 | 1 | 0 | 0 | 0 | 0 |
| 64 | 1 | 1 | 1 | 1 | 0 | 1 | 0 | 0 |
| 65 | 1 | 1 | 1 | 0 | 0 | 0 | 0 | 1 |
| 66 | 1 | 1 | 1 | 0 | 0 | 1 | 1 | 0 |
| 67 | 1 | 1 | 1 | 0 | 0 | 0 | 0 | 0 |
| 68 | 1 | 1 | 1 | 0 | 1 | 1 | 1 | 0 |
| 69 | 1 | 1 | 1 | 1 | 0 | 0 | 0 | 0 |

EP 1 117 178 A2

## FIG. 5A

fc−768kHz          fc−384kHz          fc          fc+385kHz          fc+768kHz

## FIG. 5B

b=0    b=1    b=2    b=3    b=4    b=5    b=6    b=7

48kHz | 48kHz | 48kHz | 48kHz | 48kHz | 48kHz | 48kHz | 48kHz

## FIG. 5C

b=0

1kHz

c=0    c=3    c=23
c=1    c=2    c=22

# FIG. 6

INDEX-768    INDEX-384    -3 0    INDEX+384    INDEX+768

-388 -387    -4    +381 +382    +765 +766

FIRST BIT GROUP    SECOND BIT GROUP    THIRD BIT GROUP    FOURTH BIT GROUP

EP 1 117 178 A2

# FIG. 7

EP 1 117 178 A2

INDEX-768

−3 0

−4

INDEX+768

FIRST BIT GROUP

SECOND BIT GROUP

# FIG. 8A

−384  +384

INDEX−768  INDEX+768

# FIG. 8B

−384  +384

INDEX−768  INDEX+768

# FIG. 9

FRONT END (2) → SAW (3) → IF AMPLIFIER (4) → A/D CONVERTER (5) → ORTHOGONAL DEMODULATOR (6) → FFT (7) → DIFFERENTIAL DEMODULATOR (8) → VITERBI DECODER (9) → SOUND DECODER (10)

NULL DETECTOR (11), CARRIER DETECTOR (12), RAM (13), SYSTEM CONTROL UNIT (16), ROM (17)

ARITHMETIC PROCESSING UNIT (14), CORRECTION PROCESSING UNIT (15)

50

I  Q

EP 1 117 178 A2

# FIG. 10A

# FIG. 10B

| CARRIER FREQUENCY | fc -768 | fc -767 | fc -766 | fc -765 | fc -764 | fc -763 | | fc +766 | fc +767 | fc +768 |
|---|---|---|---|---|---|---|---|---|---|---|
| CORRECTION VALUE Cv | +5 | +1 | 0 | +1 | +1 | +1 | | 0 | +1 | +5 |

# FIG. 11A

# FIG. 11B

# FIG. 12A

INDEX-768        INDEX-385

FIRST BIT GROUP

-388   -387

# FIG. 12B

INDEX-384        -3

SECOND BIT GROUP        0

-4

# FIG. 12C

0        INDEX+384

THIRD BIT GROUP

+381   +382

# FIG. 12D

INDEX+384        INDEX+768

FOURTH BIT GROUP

+765   +766

# FIG. 12E

AFTER CORRECTED

# FIG. 13

| C | b= 0 | 1 | 2 | 3 | 4 | 5 | 6 | 7 |
|---|---|---|---|---|---|---|---|---|
| 0 | * | * | * | * | 9 | 8 | 9 | 10 |
| 1 | ▪ | ▪ | ▪ | ▪ | ▪ | ▪ | ▪ | ▪ |
| 2 | * | * | * | 8 | 6 · | * | 7 | 7 |
| 3 | ▪ | ▪ | ▪ | ▪ | ▪ | ▪ | ▪ | ▪ |
| 4 | ▪ | ▪ | ▪ | ▪ | ▪ | ▪ | ▪ | ▪ |
| 5 | ▪ | ▪ | ▪ | ▪ | ▪ | ▪ | ▪ | ▪ |
| ▪ | ▪ | ▪ | ▪ | ▪ | ▪ | ▪ | ▪ | ▪ |
| ▪ | ▪ | ▪ | ▪ | ▪ | ▪ | ▪ | ▪ | ▪ |
| ▪ | ▪ | ▪ | ▪ | ▪ | ▪ | ▪ | ▪ | ▪ |
| 20 | * | 5 | * | 5 | * | 6 | * | 8 |
| 21 | | | | | | | | |
| 22 | | | | | | | | |
| 23 | | | | | | | | |

CORRECTED VALUE ⟹ 9

# FIG. 14

```
                    START

              S1
      ARE AFC AND A
NO    SAMPLING FREQUENCY
      SYNCHRONIZED WITH
      EACH OTHER ?
              YES

      SUBJECT NULL SIGNAL        S2
      TO FET

      SUBJECT A REFERENCE        S3
      SYMBOL TO FET

      CALCULATE THE POWER        S4
      OF EACH CARRIER OF
      NULL SYMBOL

              S5
      DOES THE CARRIER OF         NO
      NULL SYMBOL PORTION
      REPRESENT TII ?
              YES

      SUBJECT THE TII TO         S6
      CORRECTION BASED ON
      FILTER CHARACTERISTICS

      SUBJECT THE TII TO         S7
      CORRECTION USING A
      REFERENCE SYMBOL

              S8                        S12
      MODE 1      NO          MODE 4       NO
              YES                     YES
      AVERAGE BIT GROUPS    S9    AVERAGE THE BIT GROUPS   S13
      OF FOUR BLOCKS              OF TWO BLOCKS

      DECODE THE BIT GROUP       S10
      OF THE TII

      AVERAGE TII IN BIT         S11
      GROUPS

                    END
```